# FASCICULE DE BREVET EUROPEEN

(11) **EP 0 383 653 B1**
(45) Date de publication et mention de la délivrance du brevet: **20.04.1994**
(21) Numéro de dépôt: 90400341.5
(22) Date de dépôt: 07.02.1990
(51) Int. Cl.: G01R 31/04

(54) **Système pour tester des pièces de câblage**
System zum Prüfen von Kabelstücken
System for testing pieces of cables

(30) Priorité: 13.02.1989 FR 8901826
(43) Date de publication de la demande: 22.08.1990
(73) Titulaire: EUROCOPTER FRANCE, F-13725 Marignane Cédex (FR)
(72) Inventeur: Cerda, Léon Germain, F-13620 Carry-Le-Roue (FR)
(74) Mandataire: Bonnetat, Christian

(56) Documents cités:
- DE-B- 2 738 148
- US-A- 2 488 556
- US-A- 4 620 282
- IBM TECHNICAL DISCLOSURE BULLETIN, Vol. 27, No. 4a, septembre 1984, page 2245, New York US, G.W.Fey: "Testing Harness"
- IBM TECHNICAL DISCLOSURE BULLETIN, Vol. 26, No. 7a, decembre 1983, New York US, G.E. Casa: "Method of plugging and checking the integrity of highly dense, discretely wired computer backpanels"

## Description

La présente invention concerne un système pour tester des pièces de câblage. Par le terme "pièce de câblage", on désigne un faisceau de fils électriques ou câbles, permettant la transmission des informations et des commandes nécessaires pour le fonctionnement d'une machine complexe, notamment un aéronef.

De façon connue, pour vérifier la continuité électrique et l'isolement des liaisons et connexions de la pièce de câblage, après l'achèvement de sa fabrication en atelier et avant son montage par exemple à bord d'un aéronef, tel qu'un hélicoptère, on utilise un banc de tests spécialisé sur lequel on branche toutes les liaisons et connexions de ladite pièce de câblage. A cet effet, le banc de tests doit donc comporter tous les connecteurs complémentaires de ceux des différentes pièces de câblage à tester. Une telle disposition pour la liaison des pièces de câblage sur le banc de tests n'est pas satisfante dans la mesure où, en particulier dans le domaine aéronautique, selon le type d'aéronef et les missions pour lesquelles il est conçu, on se trouve en présence d'un grand nombre de pièces de câblage différentes à tester. Il est donc nécessaire de prévoir, sur le banc de tests, un grand nombre de connecteurs complémentaires, correspondant à ceux des pièces de câblage à tester, ce qui implique, pour le banc de tests, des dimensions telles qu'il peut être difficile, sinon impossible, de relier tel ou tel connecteur d'une pièce de câblage particulière à son connecteur complémentaire, au bon endroit, sur le banc de tests. Par ailleurs, compte tenu de la multiplicité desdits connecteurs complémentaires existant sur le banc de tests, les risques d'erreur ne sont pas négligeables.

La présente invention a pour but d'éviter ces inconvénients, et concerne un système pour tester des pièces de câblage présentant une grande souplesse d'utilisation, ainsi qu'une grande fiabilité.

On connaît de plus, par le brevet US-A-4 620 282, un système pour tester des pièces de câblage, du type comportant un banc de tests présentant des moyens de connexion pour lesdites pièces de câblage, dont chacune comporte des connecteurs, lesdits moyens de connexion comportant une pluralité d'emplacements de branchement identiques, lesdits emplacements de branchement formant des modules comportant chacun plusieurs desdits emplacements, et étant alignés de façon adjacente l'un par rapport à l'autre, et le système comprenant des dispositifs de connexion intermédiaires entre le banc de tests et la pièce de câblage à tester, chacun desdits dispositifs de connexion intermédiaires comprenant un premier connecteur complémentaire du connecteur correspondant de la pièce de câblage à tester et un second connecteur destiné à être branché sur lesdits emplacements de branchement, et ledit système comprenant des moyens de commande aptes, pour une pièce de câblage particulière, à déduire les dispositifs de connexion intermédiaires nécessaires pour relier ladite pièce de câblage audit banc de tests, ainsi que leurs modules de branchement spécifiques.

Par rapport à ce système antérieur, le système selon l'invention est remarquable en ce que le second connecteur est destiné à être branché sur certains desdits emplacements de branchement, dont la position est spécifique de la pièce de câblage à tester, en ce que lesdits premier et second connecteurs sont reliés l'un à l'autre par un câble de liaison souple, en ce que le système comprend des moyens de stockage d'une pluralité de dispositifs de connexion intermédiaires munis chacun de moyens d'identification, et en ce que lesdits moyens de commande sont aptes à commander des moyens destinés à rechercher, à l'aide de ses moyens d'identification, chacun desdits dispositifs de connexion intermédiaires pour ladite pièce de câblage particulière, dans lesdits moyens de stockage, et à signaler ledit dispositif de connexion intermédiaire.

Ainsi, à côté de la fonction de "prolongateur" exercée par chaque dispositif de connexion intermédiaire, la recherche, dans les moyens de stockage, des différents dispositifs de connexion intermédiaires pour une pièce de câblage particulière peut être automatisée, en facilitant ainsi la tâche de l'opérateur.

Avantageusement, lesdits emplacements de branchement sont prévus sur au moins un support indépendant du banc de tests proprement dit, et relié à ce dernier.

De préférence, lesdits moyens de commande sont aptes à commander des moyens permettant de désigner le ou les modules de branchement spécifiques de chacun desdits dispositifs de connexion intermédiaires sur le banc de tests. L'opérateur peut ainsi effectuer le branchement correct du dispositif de connexion intermédiaire sur le banc de tests sans risque d'erreur.

En particulier, lesdits moyens de stockage peuvent comporter au moins un support pour une pluralité de modules de raccordement des dispositifs de connexion intermédiaires, lesdits modules de raccordement étant alignés de façon adjacente l'un par rapport à l'autre.

Avantageusement, lesdits moyens de recherche et de signalisation d'un dispositif de connexion intermédiaire particulier sont montés sur un chariot susceptible de se déplacer le long dudit support.

De préférence, ledit chariot est disposé sur une bande sans fin entraînée par un moteur pas à pas.

En particulier, les moyens d'identification des dispositifs de connexion peuvent être à chaque fois constitués par un couple de résistances de valeurs spécifiques, monté dans le second connecteur de chacun desdits dispositifs de connexion, et les moyens de recherche et de signalisation des dispositifs de connexion intermédiaires peuvent comporter des moyens de mesure des valeurs des résistances desdits couples.

Selon un autre mode de réalisation de l'invention, les moyens pour désigner le ou les modules de branchement spécifiques d'un dispositif de connexion intermédiaire particulier sur le banc de tests comprennent un générateur de faisceau laser.

Les figures du dessin annexé feront bien comprendre comment l'invention peut être réalisée. Sur ces figures, des références identiques désignent des éléments semblables.

La figure 1 est une vue schématique en perspective d'un support d'une pluralité de modules de branchement identiques, monté sur un banc de tests.

La figure 2 illustre schématiquement en perspective l'ensemble du système pour tester des pièces de câblage selon l'invention, avec, en particulier, les moyens de stockage des dispositifs de connexion intermédiaires.

La figure 3 est une vue schématique en perspective, partielle montrant la face avant d'un support, appartenant aux moyens de stockage de la figure 2, d'une pluralité de modules de branchement.

La figure 4 est une vue de face, avec arrachement partiel, du second connecteur d'un dispositif de connexion intermédiaire.

La figure 5 est une vue en coupe transversale des moyens de recherche et de signalisation d'un dispositif de connexion intermédiaire particulier dans les moyens de stockage.

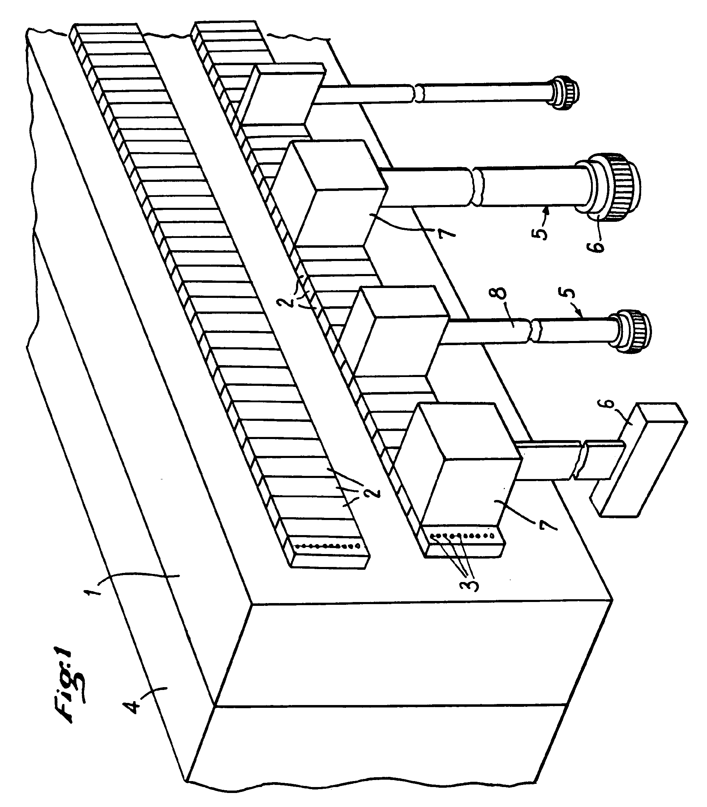

Sur la figure 1, on a représenté schématiquement un support 1 pour une pluralité de modules 2 comportant chacun plusieurs emplacements de branchement identiques 3, le support 1 étant monté sur le banc de tests proprement dit 4. (Dans l'exemple représenté, les modules 2 sont agencés en deux séries l'une au-dessus de l'autre, en étant alignés de façon adjacente l'un par rapport à l'autre dans chaque série, et on notera de plus que les emplacements de branchement 3 n'ont pas été représentés à chaque fois pour des raisons de clarté du dessin). Une autre possibilité (non représentée) consisterait à relier le banc de tests et le support, se trouvant alors en deux endroits éloignés, à l'aide d'un harnais de liaison. Le banc de tests proprement dit est connu en soi et ne sera pas décrit ici plus en détail. On rappelle simplement qu'il permet de vérifier la continuité électrique de chaque conducteur et l'isolement de chaque liaison et de chaque connexion de la pièce de câblage (non représentée). Pour relier cette dernière au support 1 et donc au banc de tests 4, on prévoit, selon l'invention, des dispositifs de connexion intermédiaires 5 dont le nombre et le type sont spécifiques d'une pièce de câblage particulière à tester. A cet effet, chaque dispositif de connexion intermédiaire 5 comprend un premier connecteur 6 complémentaire du connecteur correspondant de la pièce de câblage à tester et un second connecteur 7, relié au premier par un câble de liaison souple 8, destiné à être branché sur certains modules 2, de façon également spécifique à la pièce de câblage à tester. Un nombre différent de modules est par ailleurs nécessaire pour le branchement de l'un ou l'autre des dispositifs de connexion intermédiaires (par exemple de 1 à 4 modules, comme montré sur la figure 1).

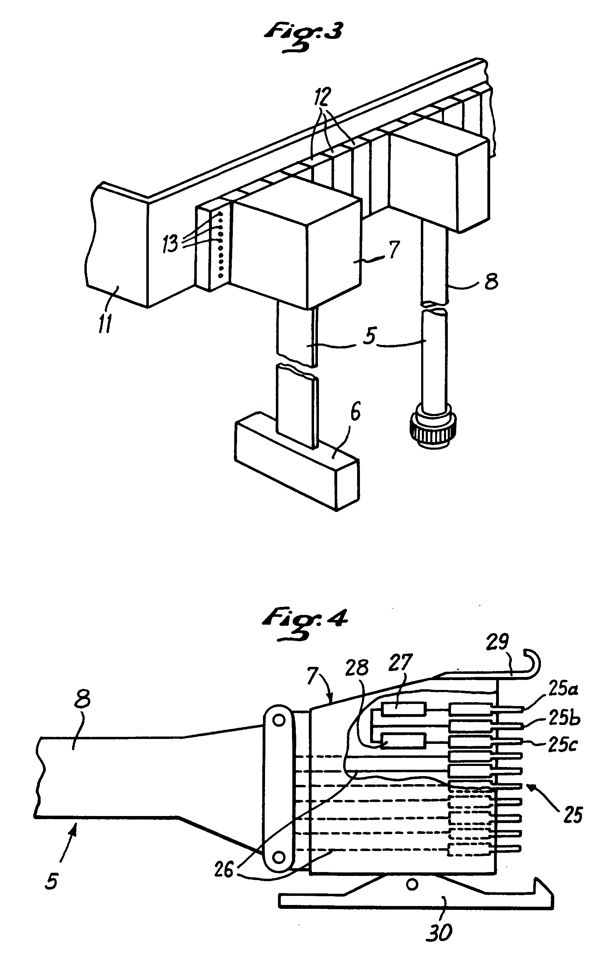

En considérant le grand nombre de dispositifs de connexion intermédiaires nécessaires pour les différentes pièces de câblage à tester, selon l'invention, on prévoit que, chaque dispositif de connexion intermédiaire 5 étant muni de moyens d'identification décrits en détail par la suite, le système de l'invention comprend de plus des moyens de stockage 10 d'une pluralité de dispositifs de connexion intermédiaires 5 se présentant de façon générale sous une forme analogue au support 1 décrit précédemment, c'est-à-dire comportant un support 11 pour une pluralité de modules 12 de branchement des dispositifs de connexion intermédiaires 5, modules alignés, sur ledit support, de façon adjacente l'un par rapport à l'autre et présentant chacun un certain nombre d'emplacements de branchement 13 (figure 3).

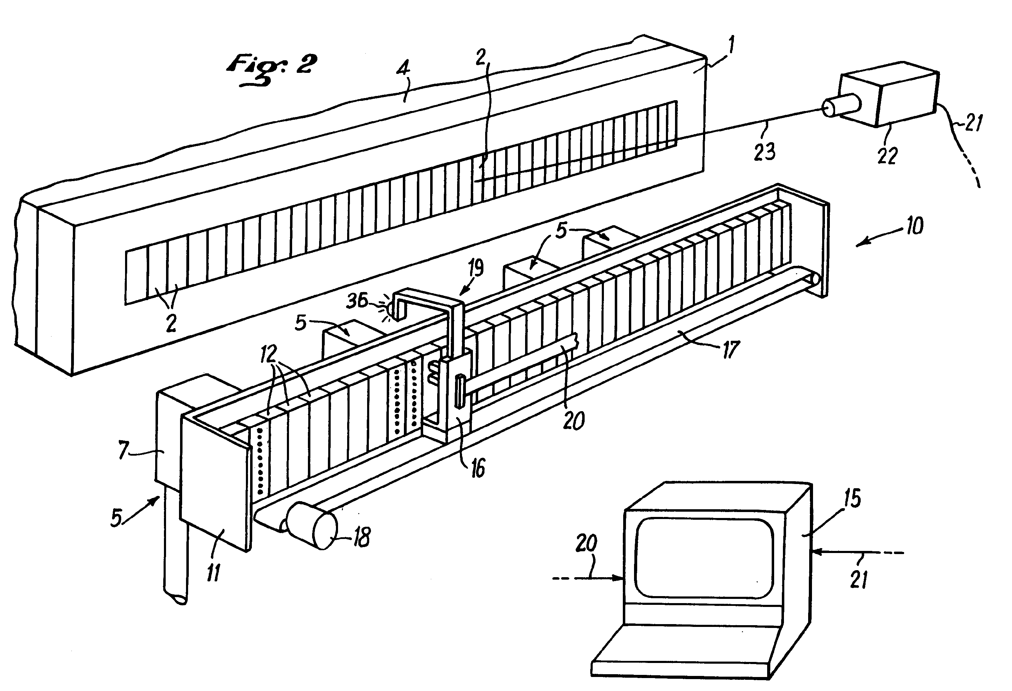

Par ailleurs, un micro-ordinateur 15 (figure 2) est utilisé pour commander, après identification de la pièce de câblage à tester (par exemple par introduction d'un code à l'aide du clavier de l'ordinateur, lecture d'un code à barres, etc...), la recherche des dispositifs de connexion intermédiaires particuliers, nécessaires pour relier ladite pièce au banc de tests, dans les moyens de stockage 10. Pour cela, il est prévu un chariot 16 susceptible de se déplacer, sur le brin supérieur d'une bande sans fin 17 entraînée par un moteur pas à pas 18, le long du support 11 et à l'arrière de celui-ci (étant entendu que les dispositifs de connexion intermédiaires sont branchés sur la face avant du support), chariot sur lequel sont montés des moyens de recherche et de signalisation 19 d'un dispositif de connexion intermédiaire particulier, décrits en détail par la suite, reliés au micro-ordinateur 15 par la liaison 20.

De plus, le micro-ordinateur 15 est relié, par la liaison 21, à un générateur à laser 22 dont le faisceau 23 est commandé pour désigner, sur le support 1 monté sur le banc de tests 4, le ou les modules de branchement 2 spécifiques du dispositif de connexion intermédiaire 5 repéré dans les moyens de stockage 10.

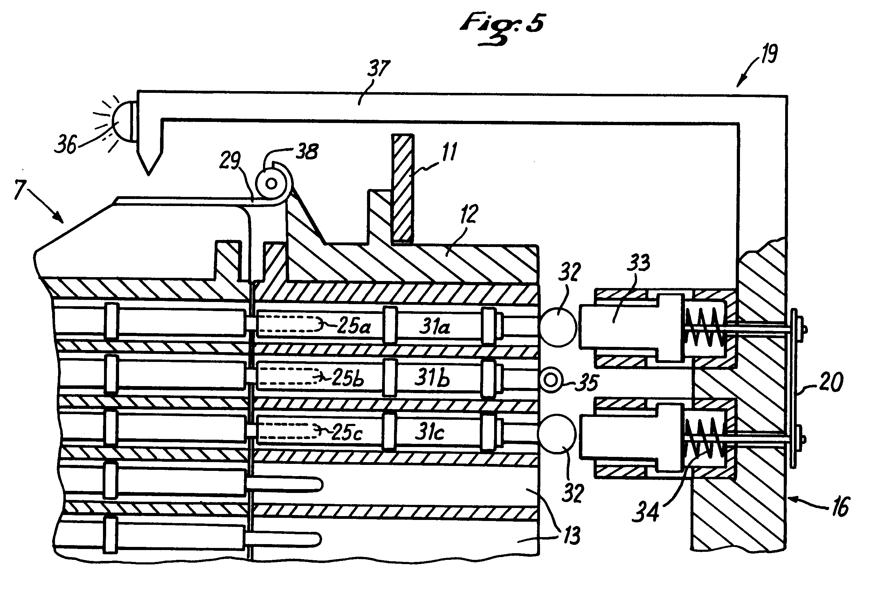

On a représenté sur la figure 4, le second connecteur 7 d'un dispositif de connexion intermédiaire 5 comportant un certain nombre de fiches 25, reliées au premier connecteur 6 (non représenté sur la figure 4) par des liaisons respectives 26, à l'exception des trois premières d'entre elles 25a,25b, 25c. Celles-ci permettent le montage, comme représenté, d'un couple de résistances 27,28 de valeurs spécifiques pour chaque dispositif de connexion intermédiaire particulier, pour l'identification dudit dispositif de connexion. Ces résistances électriques peuvent être choisies dans une gamme de valeurs comprises entre 100 Ohms et 91000 Ohms, soit 72 valeurs. Le groupement par deux de ces résistances permet d'obtenir 72 x 72 = 5184 combinaisons. Une combinaison de résistances et une seule est associée à un dispositif de connexion intermédiaire particulier.

Le connecteur 7 présente de plus des pattes d'accrochage 29,30 à un module de branchement.

En se référant maintenant à la figure 5, on a représenté partiellement un connecteur 7 branché sur un module 12 des moyens de stockage 10. En particulier, les fiches 25a,25b, 25c sont branchées sur les bornes correspondantes 31a,31b, 31c du module 12. Les bornes 31a,31c sont munies, chacune, à leur extrémité opposée à celle destinée au branchement de la fiche 25a,25c correspondante, d'un contact sphérique 32, faisant saillie du module 12, susceptible de venir au contact d'un plot 33 correspondant, sollicité par un ressort de compression 34, monté sur le chariot 16 et relié à la liaison 20. Les bornes 31b des modules 12, munies chacune d'une cosse 35 de reprise en parallèle, sont toutes shuntées entre elles. Par ailleurs, une lampe-témoin 36 permet de signaler la position du dispositif de connexion intermédiaire recherché, laquelle lampe est montée à l'extrémité d'un bras 37 solidaire du chariot 16 et s'étendant vers la face avant du support 11 des modules 12. En outre, comme montré, la patte d'accrochage 29 du connecteur 7 peut coopérer avec un organe correspondant 38 du module 12, pour maintenir le dispositif de connexion 5 sur ce dernier.

Une pièce de câblage particulière devant être testée, l'opérateur entre, tout d'abord, le code de ladite pièce dans le micro-ordinateur 15, dans la mémoire duquel sont stockées les informations relatives aux dispositifs de connexion intermédiaires nécessaires pour relier ladite pièce de câblage au banc de tests. Le déplacement du chariot 16 le long du support 11 des modules 12 est alors commandé de façon à rechercher un premier dispositif de connexion intermédiaire 5 dans les moyens de stockage 10, dispositif qui est identifié par les valeurs spécifiques du couple de résistances attribué, en tant que moyens d'identification, à chaque dispositif de connexion intermédiaire particulier. A ce propos, on notera que cette recherche permet de disposer les dispositifs de connexion intermédiaire dans un ordre quelconque sur les moyens de stockage.

Le dispositif de connexion intermédiaire souhaité ayant été repéré par la mesure des valeurs de son couple de résistances, la lampe-témoin 36 s'allume en signalant à l'opérateur l'endroit, sur le support 11, où se trouve le dispositif de connexion intermédiaire repéré. En même temps, toujours par l'intermédiaire du micro-ordinateur 15, le générateur à laser 22 est commandé de façon que le faisceau laser 23 désigne, sur le support 1 des modules 2 monté sur le banc de tests 4, la position du ou des modules 2 sur lesquels doit être branché le dispositif de connexion intermédiaire repéré. Il suffit alors à l'opérateur de retirer ledit dispositif de connexion intermédiaire du support 11, et de le mettre en place, dans la position désignée, sur le support 1. La même série d'opérations sera recommencée pour tous les autres dispositifs de connexion intermédiaires nécessaires. Sur le support de modules associé au banc de tests, une mesure de résistances permet de plus de vérifier la présence et le positionnement correct de tous les dispositifs de connexion intermédiaires nécessaires à la liaison avec la pièce de câblage particulière à tester. Cette dernière peut alors être reliée au banc de tests, chacun de ses connecteurs étant relié au connecteur complémentaire correspondant des dispositifs de connexion intermédiaires, la procédure de tests étant ensuite mise en oeuvre.

On peut ainsi, grâce à l'invention, mettre en place facilement et sans risque d'erreur différentes pièces de câblage sur le banc de tests.

## Revendications

1. Système pour tester des pièces de câblage, du type comportant un banc de tests (4) présentant des moyens de connexion (1) pour lesdites pièces de câblage, dont chacune comporte des connecteurs, lesdits moyens de connexion (1) comportant une pluralité d'emplacements de branchement identiques (3), lesdits emplacements de branchement (3) formant des modules (2) comportant chacun plusieurs desdits emplacements, et étant alignés de façon adjacente l'un par rapport à l'autre, et le système comprenant des dispositifs de connexion intermédiaires (5) entre le banc de tests (4) et la pièce de câblage à tester, chacun desdits dispositifs de connexion intermédiaires (5) comprenant un premier connecteur (6) complémentaire du connecteur correspondant de la pièce de câblage à tester et un second connecteur (7) destiné à être branché sur lesdits emplacements de branchement (3), et ledit système comprenant des moyens de commande (15) aptes, pour une pièce de câblage particulière, à déduire les dispositifs de connexion intermédiaires (5) nécessaires pour relier ladite pièce de câblage audit banc de tests (4), ainsi que leurs modules de branchement spécifiques (2),
caractérisé en ce que le second connecteur (7) est destiné à être branché sur certains desdits emplacements de branchement (3), dont la position est spécifique de la pièce de câblage à tester, en ce que lesdits premier (6) et second (7) connecteurs sont reliés l'un à l'autre par un câble de liaison souple (8), en ce que le système comprend des moyens de stockage (10) d'une pluralité de dispositifs de connexion intermédiaires (5) munis chacun de moyens d'identification (27,28), et en ce que lesdits moyens de commande (15) sont aptes à commander des moyens (19) destinés à rechercher, à l'aide de ses moyens d'identification (27,28), chacun desdits dispositifs de connexion intermédiaires (5) pour ladite pièce de câblage particulière, dans lesdits moyens de stockage (10), et à signaler ledit dispositif de connexion intermédiaire.

2. Système selon la revendication 1,
caractérisé en ce que lesdits emplacements de branchement (3) sont prévus sur au moins un support (1) indépendant du banc de tests (4) proprement dit, et relié à ce dernier.

3. Système selon la revendication 1 ou la revendication 2,
caractérisé en ce que lesdits moyens de commande (15) sont aptes à commander des moyens (22) permettant de désigner le ou les modules de branchement (2) spécifiques de chacun desdits dispositifs de connexion intermédiaires (5) sur le banc de tests (4).

4. Système selon l'une quelconque des revendications 1 à 3,
caractérisé en ce que lesdits moyens de stockage (10) comportent au moins un support (11) pour une pluralité de modules (12) de raccordement des dispositifs de connexion intermédiaires (5), lesdits modules de raccordement (12) étant alignés de façon adjacente l'un par rapport à l'autre.

5. Système selon la revendication 4,
caractérisé en ce que lesdits moyens de recherche et de signalisation (19) d'un dispositif de connexion intermédiaire particulier (5) sont montés sur un chariot (16) susceptible de se déplacer le long dudit support (11).

6. Système selon la revendication 5,
caractérisé en ce que ledit chariot (16) est disposé sur une bande sans fin (17) entraînée par un moteur pas à pas (18).

7. Système selon l'une quelconque des revendications 1 à 6,
caractérisé en ce que les moyens d'identification des dispositifs de connexion intermédiaires (5) sont à chaque fois constitués par un couple de résistances (27,28) de valeurs spécifiques, monté dans le second connecteur (7) de chacun desdits dispositifs de connexion intermédiaires (5), et en ce que les moyens de recherche et de signalisation (19) des dispositifs de connexion intermédiaires (5) comportent des moyens de mesure des valeurs des résistances desdits couples.

8. Système selon l'une quelconque des revendications 3 à 7,
caractérisé en ce que les moyens (22) pour désigner le ou les modules (2) de branchement spécifiques d'un dispositif de connexion intermédiaire particulier (5) sur le banc de tests (4) comprennent un générateur (22) de faisceau laser (23).

## Claims

1. System for testing pieces of cabling, of the type comprising a test bench (4) having connection means (1) for the said pieces of cabling, each of which comprises connectors, the said connection means (1) comprising a plurality of identical junction sites (3), the said junction sites (3) forming modules (2), each comprising several of the said sites, and being aligned adjacent to each other, and the system comprising devices (5) for intermediate connection between the test bench (4) and the piece of cabling to be tested, each of the said intermediate connection devices (5) comprising a first connector (6) complementary with the corresponding connector of the piece of cabling to be tested, and a second connector (7) intended to be joined onto the said junction sites (3), and the said system comprising control means (15) capable, for a particular piece of cabling, of deducing the intermediate connection devices (5) necessary for connecting the said piece of cabling to the said test bench (4), as well as their specific junction modules (2), characterized in that the second connector (7) is intended to be joined onto some of the said junction sites (3), the position of which is specific to the piece of cabling to be tested, and in that the said first (6) and second (7) connectors are connected to each other by a flexible linkage cable (8), in that the system comprises means (10) for storing a plurality of intermediate connection devices (5), each provided with identification means (27, 28), and in that the said control means (15) are capable of controlling means (19) intended to search, with the aid of its identification means (27, 28), for each of the said intermediate connection devices (5) for the said particular piece of cabling, from the said storage means (10), and to indicate the said intermediate connection device.

2. System according to Claim 1, characterized in that the said junction sites (3) are provided on at least one support (1), independent from the test bench (4) proper, and connected to the latter.

3. System according to Claim 1 or Claim 2, characterized in that the said control means (15) are capable of controlling means (22) making it possible to dedicate the junction module or modules (2) specific to each of the said intermediate connection devices (5) on the test bench (4).

4. System according to any one of Claims 1 to 3, characterized in that the said storage means (10) comprise at least one support (11) for a plurality of joining modules (12) for the intermediate connection devices (5), the said joining modules (12) being aligned adjacent to each other.

5. System according to Claim 4, characterized in that the said means (19) for searching for and indicating a particular intermediate connection device (5) are mounted on a carriage (16) which can move along the said support (11).

6. System according to Claim 5, characterized in that the said carriage (16) is located on an endless belt (17) driven by a stepper motor (18).

7. System according to any one of Claims 1 to 6, characterized in that the means for identifying the intermediate connection devices (5) each consist of a pair of resistors (27, 28) of specific resistances, mounted in the second connector (7) of each of the said intermediate connection devices (5), and in that the means (19) for searching for and indicating the intermediate connection devices (5) comprise means for measuring the resistances of the resistors of the said pairs.

8. System according to any one of Claims 3 to 7, characterized in that the means (22) for designating the junction module or modules (2) specific to a particular intermediate connection device (5) on the test bench (4) comprise a laser beam (23) generator (22).

## Patentansprüche

1. System zur Überprüfung von Verdrahtungsteilen, bestehend aus einem Prüfstand (4), ausgestattet mit den Anschlußvorrichtungen (1) für die genannten Verdrahtungsteile, von denen jede über Steckverbinder verfügt, wobei die Anschlußvorrichtungen (1) aus einer Vielzahl gleichartiger Anschlußstellen (3) bestehen, die Module (2) bilden, wobei jedes einzelne Modul mehrere der genannten Anschlußstellen aufweist, und eins neben dem anderen liegend angeordnet ist, und wobei das System mit zwischengelagerten Verbindungsvorrichtungen (5) zwischen dem Prüfstand (4) und dem zu überprüfenden Verdrahtungsteil ausgestattet ist, wobei jedes der zwischengelagerten Verbindungsvorrichtungen (5) einen ersten komplementären Steckverbinder (6) zu dem entsprechenden Steckverbinder des zu überprüfeden Verdrahtungsteils aufweist und einen zweiten Steckverbinder (7), der an die genannten Anschlußstellen (3) angeschlossen wird, und wobei das System mit einem Steuerungsmittel (15) ausgestattet ist, mit dem die zwischengeschalteten Verbindungsvorrichtungen (5) eines bestimmten Verdrahtungsteils abgeleitet werden können, die erforderlich sind, um das genannte Verdrahtungsteil mit dem Prüfstand (4) sowie den spezifischen Anschlußmodulen (2) zu verbinden,
das **dadurch** gekennzeichnet ist, daß der zweite Steckverbinder (7) zum Anschluß an bestimmte der genannten Anschlußstellen (3) dient, deren Position von dem jeweils zu überprüfenden Verdrahtungsteil abhängt, **dad****urch**, daß die ersten (6) und zweiten (7) Steckverbinder über ein biegsames Verbindungskabel (8) miteinander verbunden sind, **dadurch**, daß das System über Speichervorrichtungen (10) für eine Vielzahl von zwischengeschalteten Verbindungsvorrichtungen (5) verfügt, von denen jede jeweils über ein Identifikationsmittel (27, 28) verfügt, und **dadurch**, daß sich durch die genannten Steuerungsmittel (15) Mittel (19) steuern lassen, die mit Hilfe dieser Identifikationsmittel (27, 28) dazu dienen, in den Speichervorrichtungen (10) jede der zwischengeschalteten Verbindungsvorrichtungen (5) für das besondere Verdrahtungsteil zu suchen und die genannte zwischengeschaltete Verbindungsvorrichtung anzuzeigen.

2. System nach Patentanspruch 1,
gekennzeichnet **dadurch**, daß die genannten Anschlußstellen (3) auf mindestens einem Träger (1) unabhängig von dem eigentlichen Prüfstand vorgesehen sind und der Träger mit diesem verbunden ist.

3. System nach Patentanspruch 1 oder Patentanspruch 2,
gekennzeichnet **dadurch,** daß sich anhand der Steuerungsmittel (15) Mittel (22) steuern lassen, welche die Bestimmung des oder der spezifischen Anschlußmodule (2) jedes der zwischengeschalteten Verbindungsvorrichtungen (5) auf dem Prüfstand (4) ermöglichen.

4. System, nach einem der Patentansprüche 1 bis 3,
gekennzeichnet **dadurch,** daß die genannten speichervorrichtungen (10) wenigstens einen Träger (11) für eine Vielzahl von Modulen (12) zur Verbindung der zwischengeschalteten Verbindungsvorrichtungen (5) aufweisen, wobei die Anschlußmodule (12) nebeneinander angeordnet sind.

5. System nach Patentanspruch 4,
gekennzeichnet **dadurch**, daß die genannten Auffind- und Signalisationsmittel (19) einer bestimmten zwischengeschalteten Verbindungsvorrichtung (5) auf einem Wagen (16) angebracht sind, der längsseits des Trägers (11) verfahrbar ist.

6. System nach Patentanspruch 5,
gekennzeichnet **dadurch**, daß der Wagen (16) auf einem Laufband (17) montiert ist, das durch einen Schrittschaltmotor (18) angetrieben wird.

7. System nach einem der Patentansprüche 1 bis 6,
gekennzeichnet **dadurch**, daß die Auffind- und Identifikationsmittel der zwischengeschalteten Verbindungsvorrichtungen (5) sich jeweils aus einem Widerstandspaar (27, 28) mit einem spezifischen Wert zusammensetzen, die auf den zweiten Steckverbinder (7) jedes der genannten zwischengeschalteten Verbindungsvorrichtungen (5) angebracht sind und **dadurch**, daß die Auffind- und Signalisationsmittel (19) der zwischengeschalteten Verbindungsvorrichtungen (5) über Einrichtungen für die Messung der Werte der Widerstände der genannten Paare verfügen.

8. System nach einem der Patentansprüche 3 bis 7,
gekennzeichnet **dadurch**, daß die Mittel (22) zur Bestimmung des oder der spezifischen Anschlußmodule (12) einer besonderen zwischengeschalteten Verbindungsvorrichtung (5) auf dem Prüfstand (4) einen Erzeuger (22) von Laserstrahlen (23) aufweisen.
